**Europäisches Patentamt**

(19) **European Patent Office**

**Office européen des brevets**

(11) Publication number: **0 452 293 A1**

(12) # EUROPEAN PATENT APPLICATION

(21) Application number: **91850092.7**

(22) Date of filing: **10.04.91**

(51) Int. Cl.⁵: **H03H 7/01**

(30) Priority: **10.04.90 FI 901821**

(43) Date of publication of application:
**16.10.91 Bulletin 91/42**

(84) Designated Contracting States:
**AT BE CH DE DK ES FR GB GR IT LI LU NL SE**

(71) Applicant: **Haapanen, Veijo**
**Mäntyviita 3 C 23**
**SF-02110 Espoo (FI)**

(72) Inventor: **Haapanen, Veijo**
**Mäntyviita 3 C 23**
**SF-02110 Espoo (FI)**

(74) Representative: **Bjellman, Lennart Olov Henrik et al**
**Dr. Ludwig Brann Patentbyrä AB P.O Box 17192**
**S-104 62 Stockholm (SE)**

(54) **Method for tuning a filter and filter for implementing said method.**

(57) A method for tuning a filter and a filter for implementing said method, said filter comprising either a separate enclosure or a metallic enclosure (1) integral with adjoining equipment and connectors (2...5) attached to said enclosure, whereby at least one connector (2) is designed to accept an antenna for the reception/transmission of signals, and, for the reception/transmission of a signal, at least one of the connectors (3...5) is designed accept radio-frequency equipment or a mobile telephone operating in an allocated frequency band. Said filter has at least one, or alternatively, a plurality of filter components ($C_1$) connected by conductors ($S_{11}, S_{12}$) between said antenna connector and at least one of the other connectors for the purpose of providing a band-pass signal path at frequencies allocated for said radio- frequency equipment or mobile telephone, and of blocking the signal path for signals other than those intended for said radio-frequency equipment or mobile telephone. The filter is tuned according to the invention by selecting the values for the filter component ($C_1$) and the lengths of the conductors ($S_{11}, S_{12}$) to be suitable for desired filter response and then performing the final tuning of the filter by adjusting the positions of the filter component and its conductors in relation to the inner surface of the enclosure (1).

Fig.1

EP 0 452 293 A1

The present invention relates to a method according to claim 1 for tuning a filter and a filter for implementing said method.

Determination of "idealized" capacitance or inductance in an LC circuit is difficult, particularly at higher frequencies, e.g., above a few hundred MHz. This is because the physical structure of components and changes in their dimensions as well as deviations in ambient conditions can have a significant effect on the total capacitance and inductance of the circuit among other factors. Over the frequency range 100 ... 100 000 MHz, for example, it is possible to use the capacitor's own conductors even if they are straight, combined with its capacitance and, e.g., the enclosure of the circuit, in order to form series and parallel resonant circuits and, moreover, combinations of these.

By way of utilizing so-called spurious inductances and capacitances in a controlled manner according to the invention, it is possible to tune an LC circuit. The basic tuning is performed by choosing a capacitance value close to the nominal capacitance, and then complementary to the length of the capacitor's conductors, an appropriate inductance according to the desired resonant frequency. Such a design must take into account the compatibility of the resulting LC ratio with the desired use of the circuit. The final tuning is performed according to the claims disclosed herein by adjusting the positions of the capacitor section and its conductors in relation to the inner surface of the enclosure.

According to the invention it is possible to implement high-performance RF filters over the VHF range and up using only a small number components.

The present invention achieves the following advantages in relation to the prior art technology:

The number of lossy components remains low.

Use lossy printed-circuit boards for mounting of components becomes unnecessary.

Fault sources from use of components such as trimmer capacitors having a tuning shaft is avoided.

Optimized reliability and cost-effectiveness is achieved through the minimized number of components.

Filters according to the invention are readily produced and tuned.

The invention is next examined in greater detail with the help of exemplifying embodiments illustrated in the attached drawings, in which

Figure 1 shows in a top view an RF filter according to the invention for use up to 1 GHz.

Figure 2 shows in a side view the RF filter according to the invention.

Figures 3...5 show graphically the typical attenuation characteristics of a band-pass and band-stop filter according to the invention.

Figure 6 shows the lay-out of a filter according to the invention for 900/450 MHz bands.

Figure 7 shows the lay-out of another filter according to the invention for 900/450 MHz bands.

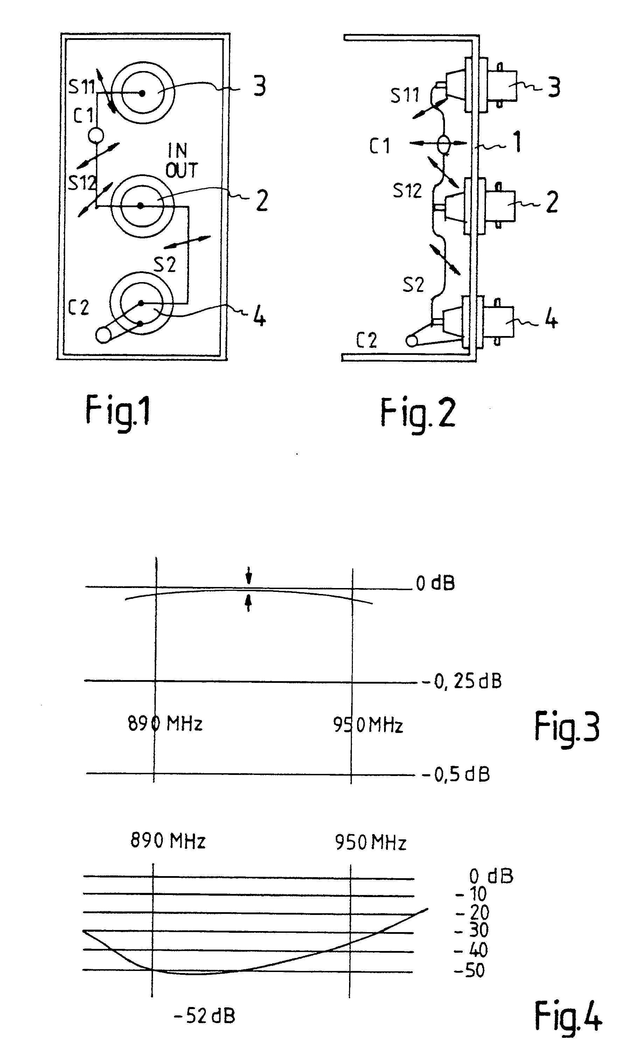

The filter illustrated in Figs. 1 and 2 is designed in a metallic enclosure 1 with straight walls fabricated from sheet metal by bending from each side. The enclosure structure can be the enclosure of either a filter or an entire radio-frequency equipment or mobile telephone. The middle section of the filter has an antenna connector 2 for attaching an antenna, while a connector 3 for a 900 MHz mobile telephone is provided on one side of the middle section (upper section in the drawings) and the other side (lower section in the drawings) is provided with a connector 4 for a radio-frequency equipment (operating below 500 MHz).

The antenna connector 2 and the connector 3 of the 900 MHz mobile telephone are connected by a capacitor $C_1$ with conductors $S_{11}$ and $S_{12}$ soldered between their center pins, said capacitor being appropriately spaced from the inner surface of the enclosure 1. The antenna connector 2 and the radio-frequency equipment connector 4 are correspondingly connected by a wire $S_2$ soldered between their center pins and bent to an appropriate distance from the inner surface of the enclosure 1. Additionally, there is connected a capacitor $C_2$ between the center pin of the radio-frequency equipment connector 4 and its base, which acts as the ground of the enclosure 1.

As described above, the filter is tuned according to the invention by utilizing the stray inductances and capacitances of the capacitor $C_1$ and the wire $S_2$ in a controlled manner. Initial tuning is performed by first selecting a capacitance value for the capacitor $C_1$ that closest approximates the design value, and then choosing a suitable inductance value to complement the lengths of the conductors $S_{11}$ and $S_{12}$ for desired frequency response.

Final tuning is performed by adjusting the positions of the capacitor section and its conductors in relation to the inner surface of the enclosure 1 as shown by the arrows. Correspondingly, the appropriate length and spacing of the wire $S_2$ from the inner surface of the enclosure 1 are initially selected. Then, the final tuning is performed analogously to the tuning procedure of the capacitor $C_1$ by moving the wire as shown by the arrows. The capacitor $C_1$ with its conductors forms a series-resonant band-pass circuit for the 900 MHz signal, while the capacitor $C_2$ blocks the 900 MHz signal from reaching the connector 4. In a corresponding manner, the received radio signal is routed to the connector 4 and blocked from reaching the connector 3.

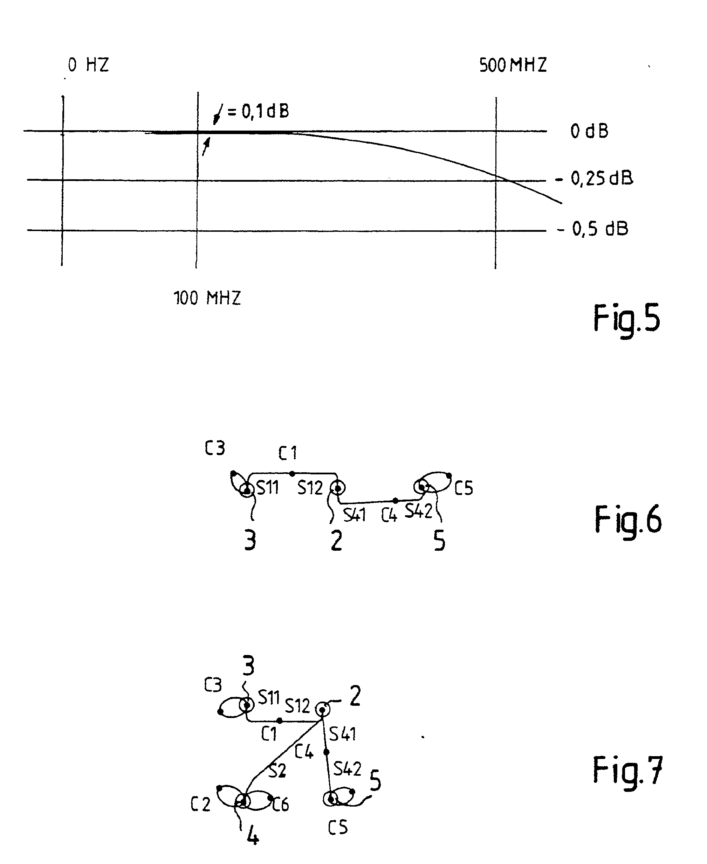

Shown in Figs. 3 and 4 are typical band-pass and band stop attenuation characteristics between the ports 3-2-3 and 4-2-4 at the 900 MHz frequency range for the filter illustrated in Figs. 1 and 2. It is evident from Fig. 3 that the band-pass attenuation is typically below 0.1 dB, while Fig. 4 shows that the band-stop attenuation maximally reaches approx. 52 dB and is approx. 35 dB minimum. It is further evident from Fig. 5 that the band-pass attenuation between the ports 4-2-4 at frequencies below 500 MHz typically remains smaller than 0.25 dB.

Fig. 6 shows a filter for the 900 MHz/450 MHz bands, said filter comprising connectors 2, 3 and 5 in linear sequence, whereby connected to the connector 3 is a capacitor $C_3$ for blocking the 450 MHz signal while the capacitor $C_1$ provides a band-pass path for the 900 MHz signal; between the connectors 2 and 5 is connected a capacitor $C_4$ for providing a band-pass path for the 450 MHz signal while a capacitor $C_5$ connected to the connector 5 blocks the 900 MHz signal. The capacitors $C_1$ and $C_4$ have conductors $S_{11}$, $S_{12}$, $S_{41}$ and $S_{42}$. Finally shown in Fig. 7 is a filter for radio-frequency equipment in the 900 MHz/450 MHz bands, said filter having its connectors 2...5 placed in a square format, whereby the above-described components are complemented with a capacitor $C_6$ at the connector 4 for filtering the 450 MHz signal at the connector 4. Tuning of the filters illustrated in Figs. 6 and 7 is carried out in a similar manner to that described in conjunction with Figs. 1 and 2.

For those versed in the art it is evident that the different embodiments of the invention are not limited by the exemplifying embodiments described above, but instead, they can be varied within the scope of the enclosed claims.

## Claims

1. A method for tuning a filter, said filter comprising either a separate enclosure or a metallic enclosure (1) integral with adjoining equipment and connectors (2...5) attached to said enclosure, whereby at least one connector (2) is designed to accept an antenna for the reception/transmission of signals, and, for the reception/transmission of a signal, at least one of the connectors (3...5) is designed to accept radio-frequency equipment or a mobile telephone operating in an allocated frequency band; said filter further having at least one, or alternatively, a plurality of filter components $(C_1, C_4)$ connected by conductors $(S_{11}, S_{12}, S_{41}, S_{42})$ between said antenna connector and at least one of the other connectors for the purpose of providing a band-pass signal path at frequencies allocated for said radio-frequency equipment or mobile telephone and of blocking the signal path for signals other than those allocated for said radio-frequency equipment or mobile telephone, **characterized** in that said filter is tuned by selecting the values for the filter component $(C_1, C_4)$ and the lengths of the conductors $(S_{11}, S_{12}, S_{41}, S_{42})$ to be suitable for desired filter response and then performing the final tuning of the filter by adjusting the positions of the filter component and its conductors in relation to the inner surface of the enclosure (1).

2. A method according to claim 1 for tuning a filter, said filter having at least one connector (4) connected by one or a plurality of conductors $(S_2)$ to an antenna connector (2), **characterized** in that the filter is tuned by first selecting the length of each the conductor $(S_2)$ to be suitable for desired filter response and then performing the final tuning of the filter by adjusting the positions of said conductors in relation to the inner surface of the enclosure (1).

3. A filter suitable for implementing the method according to claim 1, said filter comprising either a separate enclosure or a metallic enclosure (1) integral with adjoining equipment and connectors (2...5) attached to said enclosure, whereby at least one connector (2) is designed to accept an antenna for the reception/transmission of signals, and, for the reception/transmission of a signal, at least one of the connectors (3...5) is designed to accept radio-frequency equipment or a mobile telephone operating in an allocated frequency band; said filter further having at least one, or alternatively, a plurality of filter components $(C_1, C_4)$ connected by conductors $(S_{11}, S_{12}, S_{41}, S_{42})$ between said antenna connector and at least one of the other connectors for the purpose of providing a band-pass signal path at frequencies allocated for said radio-frequency equipment or mobile telephone and of blocking the signal path for signals other than those allocated for said radio-frequency equipment or mobile telephone, **characterized** in that the values for the filter component $(C_1, C_4)$ and lengths of the conductors $(S_{11}, S_{12}, S_{41}, S_{42})$ are selected to be suitable for desired filter response and that the positions of the filter component and its conductors are adjustable in relation to the inner surface of the enclosure (1) for the purpose of performing the final tuning of the filter in this manner.

4. A filter according to claim 3, said filter having at least one connector (4) connected by one or a multitude of conductors $(S_2)$ to an antenna connector (2), **characterized** in that the length of each of said conductors $(S_2)$ is selected to be suitable for desired filter response and said conductors are connected to said connectors so as to make the positions of said conductors adjustable in relation to the inner surface of the enclosure (1) for the purpose of performing the final tuning of the filter in this manner.

5. A filter according to claim 3, said filter having at least one connector (3,5) for signals above 400 MHz, **characterized** in that said connector (3,5) is connected to said antenna connector by a filter component ($C_1$, $C_4$).

6. A filter according to claim 4 or 5, said filter having at least one connector (4) for signals below 400 MHz, **characterized** in that said connector (4) is connected to said antenna connector by a conductor ($S_2$) and that for the purpose of filtering signals above 400 MHz there is a filter component ($C_2$, $C_6$) connected between the center pin of the connector (4) and a point acting as the enclosure ground.

Fig.1

Fig.2

Fig.3

Fig.4

0 HZ                                                    500 MHZ

$$\nearrow = 0,1\,dB$$

0 dB

- 0,25 dB

- 0,5 dB

100 MHZ

**Fig.5**

C3          C1

S11   S12          C5

S41   C4   S42

3          2          5

**Fig.6**

3

C3   S11 S12   2

C1   S41

C4

S2

C2   C6

CS

4

5

**Fig.7**

## EUROPEAN SEARCH REPORT

European Patent Office

Application Number

EP 91 85 0092

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | PATENT ABSTRACTS OF JAPAN, vol. 1, no. 52 (E-021), 20th May 1977; & JP-A-51 147 902 (MATSUSHITA) 18-12-1976 * Abstract * | 1 | H 03 H 7/01 |
| A | IDEM | 2-4 | |
| Y | EP-A-0 114 140 (THOMSON) * Abstract; page 3, line 27 - page 4, line 31; figure 1 * | 1 | |
| A | | 3 | |
| A | IEEE MTT-S INTERNATIONAL MICROWAVE SYMPOSIUM DIGEST, Las Vegas, Nevada, 9th - 11th June 1987, pages 365-366; J.A.G. MALHERBE et al.: "Bandstop filter in nonradiative dielectric waveguide using rectangular resonators" * Page 366, left-hand column, lines 7-16; page 366, left-hand column, line 28 - right-hand column, line 4; figure 4 * | 1 | |
| | | | TECHNICAL FIELDS SEARCHED (Int. Cl.5) |
| | | | H 03 H H 03 J H 01 P |

The present search report has been drawn up for all claims

| Place of search | Date of completion of the search | Examiner |
|---|---|---|
| THE HAGUE | 17-07-1991 | WRIGHT J.P. |

EPO FORM 1503 03.82 (P0401)